(19) Europäisches Patentamt
European Patent Office
Office européen des brevets

(11) **EP 2 110 707 A1**

(12) **EUROPEAN PATENT APPLICATION**

(43) Date of publication:
**21.10.2009 Bulletin 2009/43**

(51) Int Cl.:
*G03F 1/14* (2006.01)    *G03F 7/20* (2006.01)

(21) Application number: **08154841.4**

(22) Date of filing: **19.04.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicants:
• **IMEC**
**3001 Leuven (BE)**
• **Samsung Electronics Co., Ltd.**
**Suwon-si, Gyeonggi-do 442-743 (KR)**

(72) Inventors:
• **Lorusso, Gian Francesco**
**3090 Overijse (BE)**
• **Myers, Alan M.**
**3000 Leuven (BE)**
• **Kim, Sung**
**3080 Tervuren (BE)**

(74) Representative: **Bird, William Edward et al**
**Bird Goën & Co.**
**Klein Dalenstraat 42A**
**3020 Winksele (BE)**

(54) **Flare mapping in lithography**

(57)    A method (200) is described for determining flare for lithographic processing. The method (200) comprises obtaining (202) a point spread function for a lithographic processing system used for the lithographic processing and obtaining (204) an initial design for a mask for use in said lithographic processing. The method furthermore comprises resizing (206) the initial design and calculating (208) flare based on at least a convolution contribution of the point spread function and the resized initial design.

Fig. 2

**Description**

**Technical field of the invention**

The present invention is related to the field of optical lithography used e.g. in the manufacturing of semiconductor devices such as integrated circuits. In particular, the present invention relates to methods and systems for reducing the impact of stray light, also known as flare in EUV lithographic processes.

**Background of the invention**

In an effort to continuously increase the number of transistors per unit area on a semiconductor device, the dimensions of the features, e.g. lines, holes, spacing between lines continue to shrink. This shrinking of feature size is also referred to as scaling. Optical lithographic processing is a key technology in the manufacturing of nearly all integrated semiconductor circuits. One distinguishes between optical lithography employing electromagnetic radiation with wavelengths above 10 nm on the one hand, and non-optical lithography which employ techniques such as electron-beam lithography ("e-beam") and ion-beam lithography, on the other hand. As the geometries of the features of the components of an integrated circuit continue to shrink, it becomes more difficult to define such small features using optical lithography. A correlation, known as Raleigh's Law, exists between the wavelength of the radiation used in lithography, the numerical aperture (NA) of the optical system and the minimum dimension of the feature to be defined. This law states that the smaller the wavelength irradiation and the larger the NA, the smaller the obtainable minimum dimension. One therefore might use non-optical lithography to obtain dimensions in the nanometer scale rather than optical lithography. However these non-optical techniques still require a considerable amount of research and development efforts before becoming production-worthy. Currently, the smallest features that are defined in production-worthy lithographic techniques, use a combination of 193 nm wavelength illumination and a layer of water placed between the final lens element and the substrate where the features are being defined, thus allowing enhanced resolution. This technique is known as immersion lithography. There is a tendency in immersion lithography to further decrease the smallest feature that can be resolved by using R(esolution)-E(nhancement)-T(echniques). For example, US patent 6,686,102 discusses the problem of defining ever-smaller features by optical lithography and discloses the use of a double-exposure phase shift lithography process. However, the amount of effort required to extend immersion lithography to advanced lithographic nodes is considerable.

A very promising optical lithographic technology is known as Extreme Ultraviolet Lithogrprahy (EUVL). Whereas previous generations of exposure technology employ transmission optics (lenses) to generate a mask pattern in resist, EUVL uses reflective optics (mirrors) to form this patern. The advantage of EUVL consists of the use of soft X-ray, or EUV radiation, having a wavelength much smaller of 193nm type lithography. As a consequence, EUVL is the candidate of choice because it is easily extendible to advanced nodes. Amongst the various specific problems of EUVL, it suffers from so-called "stray light" or "flare" effects. "Flare" is an optical effect causing non-intentional irradiation of supposedly unexposed areas by light scattered by elements within the lithographic exposure tool. Flare will cause the dimensions of the features printed in the resist to change from their desired values, it will cause the line width roughness of features to increase and it will cause the tool resolution to decrease. Kafai Li et al. discuss in "Scattered light: the increasing problem for 193nm exposure tools and beyond", SPIE proceedings vol. 4346 (2001), the origin of stray light and the fact that stray light becomes more and more critical when maximizing the performance of optical lithography systems, especially when using smaller wavelengths. In transmission lithography tools, flare is caused by impurities in and on the lens elements. In reflective optics (EUVL) tools, flare results from mirror roughness in the mid spatial frequency range. Because flare is inversely proportional to the square of the wavelength of light used to form the feature image, flare will be significantly worse for EUVL systems as compared to 193 nm or 248 nm lithographic tools. For example, the Alpha Demo Tool from ASML has a flareof approximately 16%. By improving the polishing technology in the lens manufacturing process, 1st generation EUVL production tools are expected to have flare levels of approximately 8%. This is still very large compared to the level of flare on current transmission optics production tools.

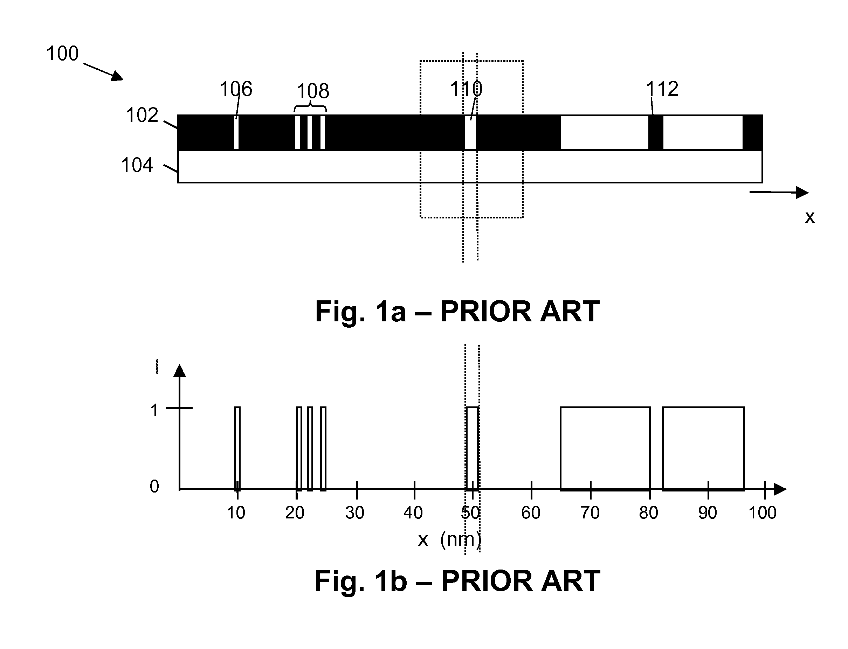

Fig. 1a to Fig. 1e illustrate the influence of stray light on the dimensions of various patterns to be formed in a layer of resist during EUV lithography using for example a reflective mask with a light absorbing pattern introduced on it. Fig. 1a shows a cross-sectional view of a mask 100 comprising an absorbing layer 102, such as e.g. a Tantalum Nitride layer, formed upon a reflective layer consisting of pairs of Molybdenum and Silicon 104. These reflective pairs are commonly referred to as a Bragg reflector. The light-absorbing layer 102, shown by way of example in Fig. 1a, could contain a pattern of a small isolated opening 106, or a grating 108 i.e. for example a sequence of 3 openings or of 2 lines, or an isolated opening 110 and an isolated line 112. Fig. 1b shows, as function of the position x along the mask 100, for each position whether radiation is being reflected, represented by an intensity I equal to "1", or is being absorbed, represented by an intensity I equal to "0". Such pattern data can be considered as a digital representation of the pattern present in a layer. In the ideal case, the spatial distribution of the radiation leaving each opening within the light-absorbing layer 102 can be represented by a function having a box profile, or mathematically by a Kronecker delta-function.

However, in reality when defining small geometries in an optical system, only the zero and first orders of the diffracted light coming off the mask are captured by the imaging system and the box function in this case is best represented by a sine wave. A given pitch of lines for example will have a particular frequency and intensity of light present being represented by a sine wave. Flare, caused by mirror roughness of the optical projection system, will result in the maximum of the sine wave being decreased (less light available in the bright areas that are being patterned) and the minimum of the sine wave being increased (the dark areas are brighter).

After being reflected by the openings in the mask 100, the reflected light will pass through the optical system and then impinge upon a substrate 150 comprising a resist or photosensitive layer 140 placed on a layer to be patterned 142. The point spread function (PSF(x,y)) of the optical system is a mathematical function that can be used to describe how the image formed at the mask is blurred by the projection system. The convolution of the point spread function with the mask design (D(x,y)) is used to describe the flare at any point of the substrate being imaged. This can be represented mathematically as

$$Flare(x, y) = \int_{0}^{\infty} PSF(x, y) \otimes D(x, y)dx, dy \qquad [1]$$

The range of the point spread function in EUVL systems can be tens of millimetres in range (as compared to tens of micron in 193nm lithography), thus the convolution calculation is extremely computationally intensive requiring extremely powerful computers and taking very long periods of time to run.

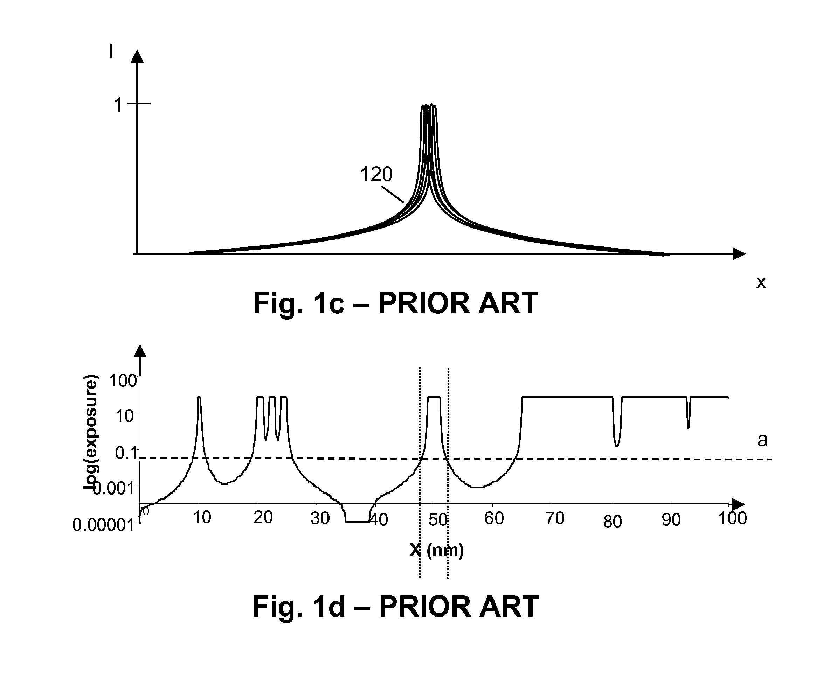

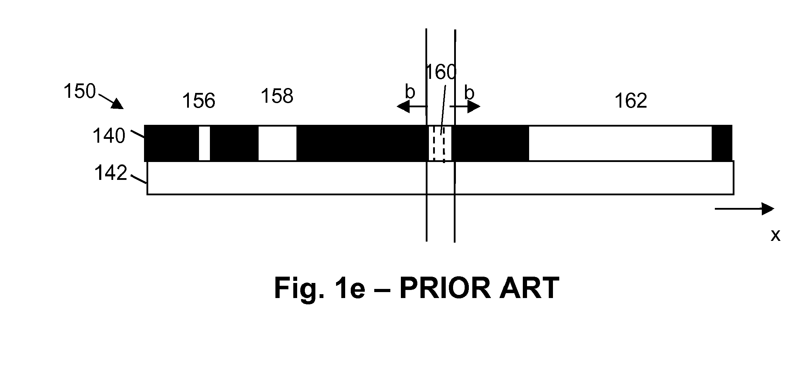

In the ideal case the pattern data of the resist, i.e. the information where resist is removed or remains, should match the pattern data of the mask pattern, i.e. where the light absorbing layer 102 is present or absent However, as set out above, as the reflected light is scattered by the projection optics, areas not aligned to the openings in the mask will be irradiated to an extent determined by equation 1. Mathematically speaking, flare effects can be described by the convolution of the pattern data of the mask, shown in Fig. 1b, with the point-spread function of the reflected light given by equation [1], as e.g. illustrated in Fig. 1c. The amount of radiation impinging on the substrate is represented in Fig. 1d. The resulting pattern generated based on this irradiation (shown in Fig. 1e) shows deviating feature dimensions compared to the feature dimensions of the original mask. So flare will result in a deviation of the desired dimensions of the features of the integrated circuit and this stray light will limit the performance of the optical lithography tool.

One way to reduce the impact of stray light on dimension is to reduce the amount of stray light in the optical lithographic tool itself, e.g. by reducing surface roughness of the projection optics mirrors. This however requires mirror polishing capabilities beyond current technology. Another way to reduce flare effects is by applying compensation using a local dark field approach. A disadvantage thereof is that the region over which this technique can be applied is limited since there is only limited space in which dummy features can be placed.

A third and more effective way to compensate for the feature size variation induced by flare is to modify the original design and to change the lateral dimensions of the pattern taking into account the induced variation. In the example illustrated by Fig. 1a to Fig. 1e this would imply that the lateral dimensions, i.e. the size of e.g. an opening, is modified to compensate for the local flare level as determined by equation 1. This bias of the lateral dimensions would hence compensate upfront for the induced CD reduction caused by flare.

In order to apply the above indicated compensation strategy, a good knowledge of the amount of induced flare must be known. The more accurate such a calculation can be performed, the more accurate the compensation for flare that can be applied. At present, calculation of flare occurring for a given lithographic process is computationally very demanding. Therefore, some techniques for calculating flare for lithographic processing with reduced computational effort have been developed. One technique is to truncate a point spread function, resulting in significant loss of accuracy. Another solution is to separate the contributions of flare into short range flare effects and long range flare effects. Also this technique results in a significant loss of accuracy.

There is still a need for good methods for determining flare e.g. flare maps for lithographic processing.

## Summary of the invention

It is an object of embodiments of the present invention to provide good methods and systems for setting up lithographic processing. It is an advantage of embodiments according to the present invention that methods and systems are provided allowing determination or estimation of flare effects, e.g. determination or estimation of flare maps, with a good accuracy, while still providing a computational efficient method and/or system. It is an advantage of embodiments according to the present invention to provide methods and systems that can be performed in a small or reasonable calculation time. It is an advantage of embodiments according to the present invention to provide methods and systems that provide accurate results. It is an advantage of embodiments according to the present invention that long-range flare, i.e. flare effects occurring at a distance of the order of millimetres from the projection of the point source, can be taken into account.

The above objective is accomplished by a method and device according to the present invention.

The present invention relates to a method for determining flare for lithographic processing, the method comprising obtaining a point spread function for a lithographic processing system used for the lithographic processing and obtaining an initial design for at least part of a mask for use in said lithographic processing. The method also comprises resizing the initial design and calculating flare based on at least a convolution contribution of a convolution of the point spread function and the resized initial design. It is an advantage of embodiments according to the present invention that information regarding flare can be obtained with appropriate accuracy while still having a good computational efficiency. It is an advantage of embodiments according to the present invention that methods and systems are provided resulting in a computational gain of at least over 4 orders, optionally over 5 orders, optionally even over 6 orders and further optionally over 7 orders of magnitude compared to conventional flare mapping techniques.

Calculating flare may comprise taking into account the at least a convolution contribution of a convolution of the point spread function and the resized initial design in a first convolution interval and taking into account a convolution contribution of a convolution of the point spread function and a non-resized initial design in a second convolution interval. The convolution interval may be an interval representative for the distance between a point of interest of the design where a flare contribution is to be determined and the position of the flare source projected onto the design.

Calculating flare may comprise taking into account a plurality of convolutions contributions of convolutions of point spread functions and resized initial designs for different convolution intervals.

Calculating flare may comprise obtaining different convolution contributions for different convolution intervals, whereby the different convolution intervals are logarithmic intervals. It is an advantage of embodiments according to the present invention that long range flare effects can be appropriately taken into account.

For different convolution contributions, the value used for the point spread function in the contribution may be the average value of the point spread function intensity in the corresponding convolution interval or an approximation thereof.

The method may comprise determining, based on calculated flare, a flare map for a predetermined lithographic process. It is an advantage of embodiments according to the present invention that full-chip flare maps can be obtained with high resolution, whereby the flare maps both have a high accuracy and can be determined with an appropriate computational efficiency.

Said resizing of the initial design in the at least one convolution contribution may be selected so as to determine a convolution contribution expressing the flare contribution at larger distance from a flare source with a different data density in the design than a convolution contribution describing the flare contribution at shorter distance from the flare source.

For a plurality of convolution contributions, the amount of resizing may be larger for convolution contributions expressing the flare contribution at larger distance from the flare source, than the amount of resizing for convolution contributions expressing the flare contribution at short distance from the flare source.

The present invention further relates to a method for designing a mask for lithographic processing, the method comprising determining information regarding flare based on a method as described above, the method further comprising evaluating the information regarding flare as function of a threshold for developing resist, and adjusting an initial design for the mask as function of said evaluated information regarding flare. It is an advantage of embodiments according to the present invention that the obtained flare information can be directly applied for obtaining adjusted masks for lithography.

The present invention also relates to a mask for lithographic processing designed using a method for designing as described above.

The present invention furthermore relates to a system for determining flare for a lithographic process, the system comprising an input means or input unit adapted for obtaining a point spread function, an input means or input unit adapted for obtaining an initial design of the mask, and a processing means comprising a resizing means adapted for resizing the initial design and comprising a calculating means adapted for calculating flare based on at least a convolution contribution of the point spread function and the resized initial design.

The present invention also relates to a system for designing a lithographic mask, the system comprising a system for determining flare as described above and an evaluation means for evaluating the determined flare as function of a threshold for said resist as well as a processing means for deriving based on said evaluated determined flare an altered design.

The present invention also relates to a computer program product for executing, when executed on a computing means, a method for determining flare as described above. The present invention also relates to a machine readable data storage device storing such a computer program product and/or the transmission thereof over a local or wide area telecommunications network.

Particular and preferred aspects of the invention are set out in the accompanying independent and dependent claims. Features from the dependent claims may be combined with features of the independent claims and with features of other dependent claims as appropriate and not merely as explicitly set out in the claims.

The teachings of the present invention permit the design of improved methods and apparatus for lithographic processing, as well as in improved devices made using such lithographic processing.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

FIG. 1a to FIG. 1e illustrate the effect of flare on dimensional features of the components to be manufactured, as is known from prior art.

FIG. 2 is a schematic representation of an exemplary method for determining flare effects that may occur using a given mask according to embodiments of the present invention.

FIG. 3a and FIG. 3b are schematic representations of image resizing illustrating image format reduction and image format enlargement as can be used according to embodiments of the present invention.

FIG. 4 is a schematic representation of a comparison of the calculation time required for a rigorous convolution as known from prior art and a decomposed convolution, the latter as function of the number of different convolution contributions based on different resized initial designs, as can be used according to embodiments of the present invention.

FIG. 5 is a comparison illustrating the accuracy for the flare from a conventional rigorous convolution and for the flare for a decomposed convolution based on 6 convolution contributions based on different resized initial designs, as can be used according to embodiments of the present invention.

FIG. 6 is a schematic representation of a logarithmic/logarithmic sampling of a point spread function, as can be used in embodiments according to the present invention..

FIG. 7 is a schematic representation of a calculated flare map as can be obtained using a method according to an embodiment of the present invention.

FIG. 8 is a schematic representation of an exemplary system for determining flare that will occur using a given mask according to an embodiment of the present invention.

FIG. 9 is a schematic representation of a computing system that may be used for performing methods according to an embodiment of the present invention.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn to scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments. As reflected in the claims, inventive aspects lie in less than all features of a single disclosed embodiment. Thus, the claims following the detailed description are hereby expressly incorporated into this detailed description, with each claim standing on its own as a separate embodiment of this invention. Combinations of features of different embodiments are also meant to be within the scope of the invention, and form different embodiments, as would be understood by those in the art. For example, in the following claims, any of the claimed embodiments can be used in any combination.

Some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

The following terms are provided solely to aid in the understanding of the invention.

With optical lithography, reference is made to lithographic processing using any type of electromagnetic radiation such as for example lithographic processing using visual light, lithographic processing using ultraviolet radiation, lithographic processing using deep ultraviolet radiation and extreme ultraviolet lithography ("EUV"). Optical lithography may therefore refer to lithography employing electromagnetic radiation with wavelengths above 10nm, such as for example 248nm or 157nm and EUV radiation or such as for example using a wavelength of 13.5nm.

A point spread function or point spread function data describes the response of an optical system, e.g. an optical lithography system, to a light point source.

Flare or stray light effects may be caused for example by mirror roughness with spatial wavelengths in the range of 1mm to 1$\mu$m. It is proportional to the inverse of the square of the wavelength. It results in a loss of contrast due to scattering of light from the bright regions of the image plane into the dark regions of the image plane.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

The invention can be used for optical lithographic processing wherein flare, also referred to as stray light effects, occur. The method is especially useful in EUV lithography, wherein flare can extend over regions that are tens of millimetres in extent. It can be applied for stepping as well as for scanning lithographic processing or a combination of stepping and scanning lithographic processing.

In a first aspect, the present invention relates to a method and/or system for determining flare effects, e.g. by determining flare maps, in lithographic processing. Determining flare thereby may comprise calculating and/or mathematically estimating flare effects. The method comprises obtaining an initial design for at least part of the mask that will be used in the lithographic processing for obtaining the pattern in the device to be made and obtaining a point spread function representative of the optical system. The technique may be applied for part of the mask or for the full mask. The method further comprises determining a convolution of the point spread function with the design and determining, based on said convolution of the point spread function with the design, the flare that will occur in all the imaged area. According to embodiments of the present invention, methods and systems are provided wherein the method comprises resizing the design into a resized initial design and calculating flare based on at least a convolution contribution of the point spread function with the resized initial design in a given convolution interval. The method may comprise determining a convolution of the point spread function and the resized initial design for some distance interval and determining a convolution of the point spread function and the non-resized initial design in another distance interval for the convolution. The convolution interval thereby may be an interval for the distance between the point of interest wherein the flare contribution is to be determined and the point on the design representative for the flare source. It has been found that the calculation time for appropriately determining flare effects for a design, e.g. a full chip design, can be significantly reduced. The reduction can be up to 2 orders of magnitude, even up to 3 orders of magnitude or even up to 4 orders of magnitude. Calculating flare effects may comprise resizing the design for the mask, calculating the convolution integral and rescaling the obtained flare map back to the original size. In some embodiments according to the present invention, determining a convolution contribution of the point spread function with the resized design and determining a convolution contribution of the point spread function with the non-resized design.

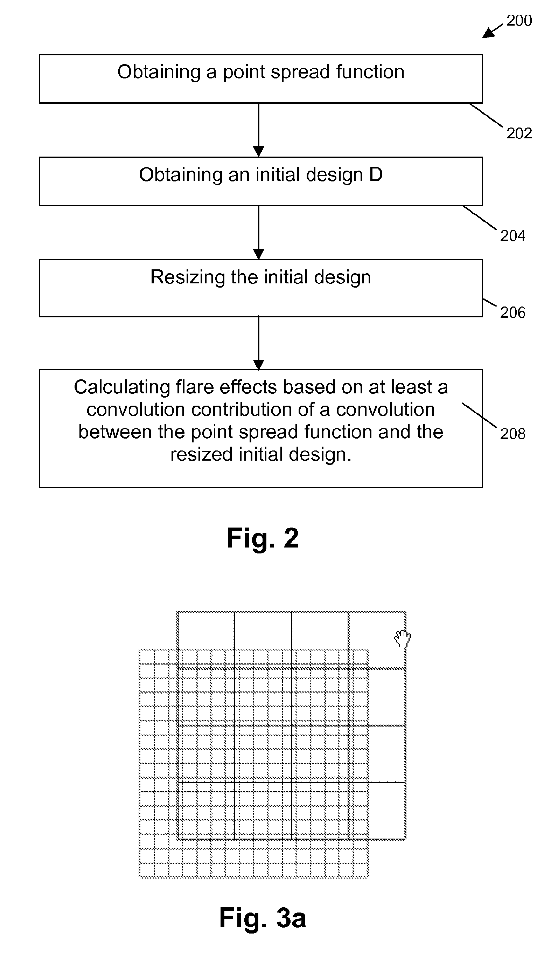

By way of illustration, the present invention not being limited thereto, an example of a method 200 according to embodiments of the present invention is shown in FIG. 2, showing standard and optional steps.

In a first step 202, the method comprises obtaining a point spread function. The point spread function may be derived experimentally for a given lithographic processing system, it may be obtained from literature or it may be calculated. Obtaining may comprise receiving a previously stored point spread function from a memory.

In a second step 204, the method comprises obtaining an initial design D for at least part of a mask for lithographic processing. The initial design may be a design for part of the mask that will be used in lithographic processing or it may be a design for the full mask that will be used in lithographic processing. The initial design comprises the pattern information of the pattern to be implemented. Typically the design may be contained in a Graphic Design System (GDS) or Open Artwork System Interchange Standard (OASIS) file format. The initial design may be a binary design, i.e. only containing the pattern information of the design. Alternatively, it also may be a resolution enhanced techniques (RET) design, comprising, in addition to the pattern information of the design, additional features to improve to resolution of the mask, allowing smaller features to be printed. One example is an Optical-Proximity-Correction-mask (OPC-mask) comprising subresolution (sublithographic) assist features being smaller than the smallest design feature at certain positions, e.g. at corners, to correct for the light distribution at these positions.

It is to be noticed that the order in which these obtaining steps are performed is not limiting and may be interchanged. The two steps also may be performed simultaneously.

According to embodiments of the present invention, flare effects will be determined based on a convolution of the point spread function with the design in one or another format. Without being bound by the mathematical formalism used for expressing such a convolution, in one example, such a convolution expressing flare effects on position x, y may be mathematically expressed, as also indicated above, as

$$Flare(x, y) = \int_0^\infty PSF(x, y) \otimes D(x, y)dx, dy \qquad [1]$$

In the further description, the mathematical formalism used by way of illustration will be a calculus based formalism, the invention not being limited thereto. As has been indicated, the distance over which point spread functions still can contribute can be large, i.e. up to several millimetres. Whereas in principle the convolution could be determined for contributions at very large distances, in practice, the convolution is limited to distances smaller than the largest diameter of the field size being printed, as light contributing outside the field size will not influence features of the substrate anymore. Nevertheless, for a standard reticle size (33mm x 26mm), a conventional rigorous convolution with a 5 $\mu$m grid would take about 261 years with currently commercially available simulation software; It is clear that this is not an acceptable option. According to embodiments of the present invention, at least one convolution contribution of the point spread function (PSF) with a resized design is taken into account, leading to a computational more efficient technique.

In a third step 206, the method comprises resizing the initial design The design advantageously is represented as an image of a given size. According to embodiments of the present invention, convoluting is performed so that at least for part of the convolution between the point spread function and the design, the convolution is performed with a resized design representation, e.g. a resized design image. According to embodiments of the present invention, resizing may comprise an image reduction step and/or an image enlargement step. Resizing the dataset may be performed for reducing the number of samples to be treated for contributions of long range flare. The latter reduces the amount of calculation that needs to be performed, resulting in a more computationally efficient system. By way of example, the present invention not being limited thereto, image reduction may be performed through sampling. Sampling reduces the size of the image by extracting pixels e.g. on a periodic sample grid. Another example of resizing comprises averaging. When applying averaging, a sub-set of pixels is replaced by one or a smaller number of pixels having a pixel intensity which is the average of the pixel intensities of the different pixels in the sub-set or a function thereof. Still other examples are applying nearest neighbouring sampling, bilinear interpolation, cubic convolution, cubic spline interpolation, using radially symmetry kernels, etc.

In addition thereto, resizing may also be used to bring the convoluted image back to the original size of the design image. Resizing thus also may comprise image enlargement. Such image enlargement may be based on pixel replication, whereby one pixel may be replaced by a set of pixels all having the same pixel intensity. Another example of image enlargement is applying interpolation. Examples of interpolation techniques are bilinear interpolation and bicubic interpolation, although the invention is not limited thereto.

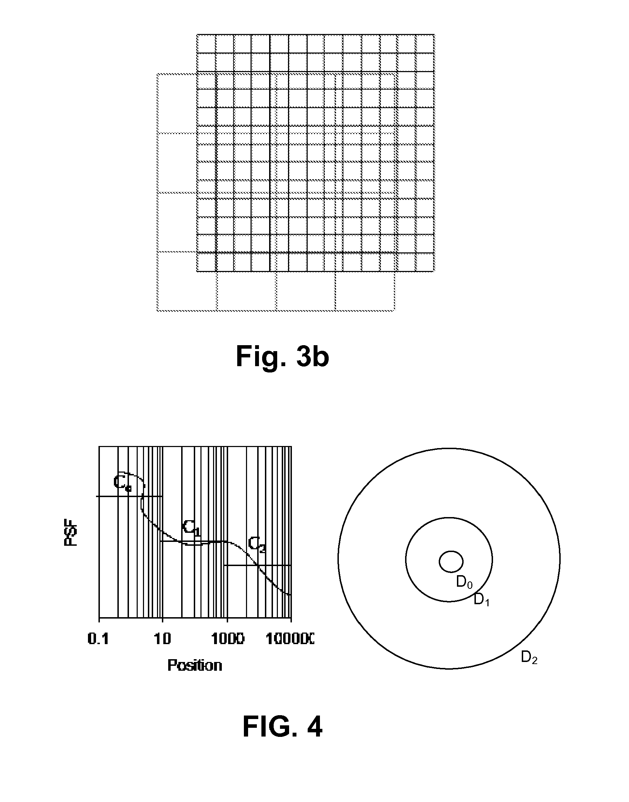

A schematic representation of two types of resizing is shown in FIG. 3a and FIG. 3b. In FIG. 3a the example of image format reduction is shown, whereby the image is reduced from 16x16 pixels format to 4x4 pixels format. In FIG. 3b, the example of image enlargement is shown, whereby the image is enlarged from 4x4 pixels format to 16x16 pixels format.

In step 208, the method comprises calculating flare effects based on at least a convolution contribution of the point spread function (PSF) with the resized design (D).

A mathematical expression for flare effects according to embodiments of the present invention therefore can be expressed as

$$D(x, y) \xrightarrow{\quad resizing \quad} D_{resized}(x, y) \qquad [2]$$

indicating the at least partly resizing of the initial design, and

$$Flare_{resized}(x, y) = f_{convolution}\big(PSF(x, y), D_{resized}(x, y)\big) \qquad [3]$$

indicating that the flare effects, e.g. under the format of a resized flare map being resized with respect to the initial design format, can be expressed as a convolution function of the point spread function and, for at least part of the convolution, a resized representation of the initial design. In one embodiment, the flare may be expressed as a convolution of the point spread function with the resized representation of the initial design over the full convolution interval, as expressed in equation [4].

$$Flare_{resized}(x, y) = \int_0^\infty PSF(x, y) \otimes D_{resized}(x, y)dx, dy \qquad [4]$$

This expresses that for a given design, the resized design is used for the full convolution integral interval. In order to bring the obtained flare map back to the original initial design format, the obtained flare map based on a resized initial design may be enlarged again to that format.

According to particular embodiments, the present invention not being limited thereto, determining flare contributions may comprise determining different convolution contributions for different intervals, which may mathematically be expressed as a decomposition of the convolution integral.

This results in a decomposition of the convolution according to different contributions depending on the distance between the source of the contribution and the point of the design wherein the contribution is determined. In other word, for each point of the design or pattern contributions based on light scattering from all other distances are classified according to the distance between the neighbouring point and the point of the design or pattern. For example, for part of the convolution integral interval, the original representation of the initial design can be used, whereas for other parts of the convolution integral interval, a resized representation of the initial design can be used. The latter is expressed in equation [5], i.e. whereby flare effects are determined by

$$Flare_{resized}(x, y) = \int_0^a PSF(x, y) \otimes D(x, y)dx, dy + \int_a^\infty PSF(x, y) \otimes D(x, y)dx, dy \qquad [5]$$

resulting in an expression of the flare effects being a sum of two contributions,

$$Flare_{resized}(x, y) = flare_{[0,a]}(x, y) + flare_{resized,[a,\infty]}(x, y) \qquad [6]$$

indicating that the flare effects are determined by two flare map contributions. The flare effects then can be expressed in a single flare map having the same format of the initial design, after again resizing the flare contribution based on the resized design to the original design format and summing both contributions.

Another example thereof is that a plurality of different resized representations of the initial design may be obtained and used in a plurality of different parts of the convolution integral interval

$$Flare_{resized}(x,y) = \int_0^{a_1} PSF(x,y) \otimes D(x,y)dx,dy + \int_{a_1}^{a_2} PSF(x,y) \otimes D_{resized,1}(x,y)dx,dy +$$

$$\int_{a_2}^{a_3} PSF(x,y) \otimes D_{resized,2}(x,y)dx,dy + ... + \int_{a_n}^{a_\infty} PSF(x,y) \otimes D_{resized,n}(x,y)dx,dy \qquad [7]$$

$$Flare_{resized}(x,y) = flare_{[0,a1]} + flare_{resized,[a1,a2]} + flare_{resized,[a2,a3]} + ... flare_{resized,[an,\infty]} \qquad [8]$$

indicating that the flare effects are determined by a plurality of n flare map contributions. The flare effects then can be expressed in a single flare map having the same format of the initial design, after again resizing the different flare contribution based on the resized design to the original design format and summing these resized contributions. Alternatively, the flare map also may be determined in another format. In order to express the flare effects in a single flare map, resizing of the different contributions to a same selected format may be performed.

The amount of resizing performed may depend on the position of the design portion with respect to the source of the contribution. For example, at large distances of the source, the amount of resizing performed may be larger than at short distances to the source.

In some embodiments according to the present invention, the method thus comprises scaling the mask design to a smaller number of pixels, calculating the convolution integral, and then resizing the results to the original size.

According to some embodiments of the present invention, the point spread function may be a different function for each of the different contributions. It is an advantage of embodiments according to the present invention that the points spread function used for determining the particular contribution can be selected as a function of the distance between the point where the light scattering is occurring and the location wherein the contribution is determined. In some embodiments, the point spread function may be a function, i.e. for the short range contributions, whereas for the further components, i.e. for the large range contributions, the point spread functions may be selected to be constant. For example, whereas for short range contributions the point spread functions may be considered fast decaying exponential functions for large range contributions it may be a constant. It is an advantage of embodiments according to the present invention that it takes into account the strong variation that occurs in the point spread function as function of the distance between the point where the light scattering is occurring and the point of evaluation. In another embodiment, for the different components of the decomposition of the convolution, the point spread function may be considered constant within the range defined by the component. The latter can be for example mathematically expressed as

$$Flare_{resized}(x,y) = C_0 \int_0^{a_1} D(x,y)dx,dy + C_1 \int_{a_1}^{a_2} D_{resized,1}(x,y)dx,dy +$$

$$C_2 \int_{a_2}^{a_3} D_{resized,2}(x,y)dx,dy + ... + C_n \int_{a_n}^{a_\infty} D_{resized,n}(x,y)dx,dy \qquad [9]$$

Wherein $C_0$, $C_1$, $C_2$, ..., $C_n$ are constants, such as for example the average value of the point spread function in the corresponding distance ranges. By way of illustration, the present invention not being limited thereto FIG. 4 provides an example of the determination of different constants for the different components. By calculating the integral in the different components of the decomposed convolution given in equation [9], equation [9] can then be rewritten as

$$\int_0^\infty PSF \otimes D = C_0 D_0 + C_1 D_1 + C_2 D_2 + ... + C_n D_n \qquad [10]$$

In one particular embodiment, the decomposition is performed by non-equal spacing of the intervals in which the convolution is decomposed. The intervals may be selected logarithmic in size or span width. In other words, logarithmic sampling in space may be performed. In other words, the different components of the decomposition of the convolution correspond to contributions of light spreading over distances classified in different logarithmic classes. One particular example could for example be, the present invention not being limited thereto,

$$\int_{0}^{\infty} PSF \otimes D = \int_{0}^{0.1\mu m} PSF \otimes D + \int_{0.1\mu m}^{1\mu m} PSF \otimes D + \int_{1\mu m}^{10\mu m} PSF \otimes D + \int_{100\mu m}^{1000\mu m} PSF \otimes D + ... + \int_{10000\mu m}^{\infty} PSF \otimes D$$

In this example the distances are classified in following logarithmic classes $[0,0.1\mu m[, [0.1\mu m,1\mu m[, [1\mu m,10\mu m[, [10\mu m, 100\mu m[, [100\mu m,1000\mu m[, [1000,10000\mu m[$ and $[10000,\infty[$. In other words, for determination of the convolution, logarithmic sampling may be performed. Whereas combining sampling and factorization results in term of speed in a gain of about 3 orders of magnitude, combining this with resizing of the design may result in a gain of about 6 to 7 orders of magnitude compared to conventional flare map calculation techniques. It is an advantage of embodiments according to the present invention that apply combination of sampling and interpolation that an appropriate accurateness is obtained for the flare effects.

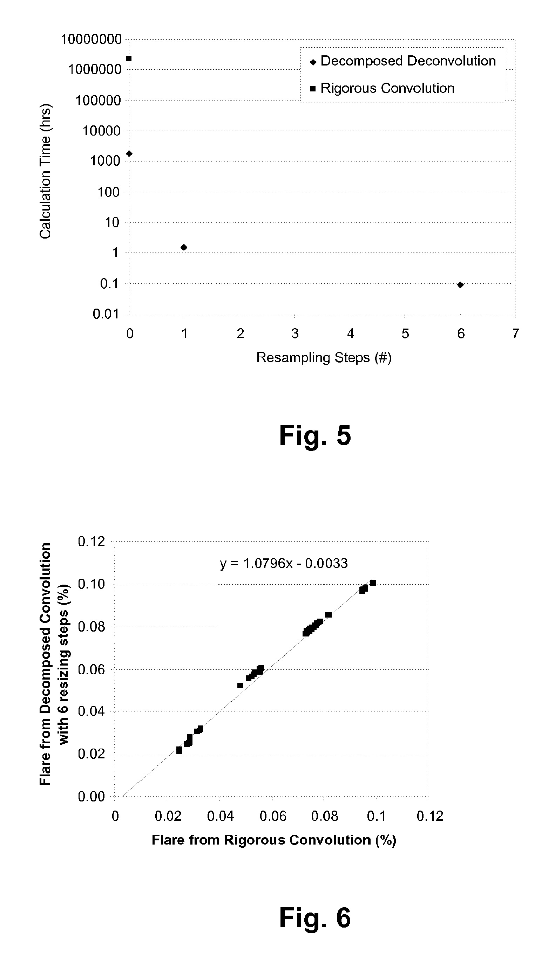

By way of illustration, the present invention not being limited thereto, in FIG. 5 an illustration is given of the calculation time (in hours) for a conventional rigorous convolution calculation and for a calculation based on a decomposed convolution based on resized design images. It can be seen that depending on the number of different convolution contributions obtained using different resampled design images results in a significant reduction of the calculation time. The gain between a rigorous calculation and a calculation using a method according to the present embodiments is up to 7 orders of magnitude, e.g. if the convolution is split in 7 contributions, each of these contributions based on a different resampled design. The scale applied for resampling can vary. In one example resizing a 3X3 pixel area in 1 pixel may be performed, resulting in a gain of a factor 9. In another example the image is resampled at a ratio 27 to 1. As indicating resizing may use interpolation and/or averaging. It may be particularly advantageous to use interpolation in the resizing function. The latter may be computationally more efficient.

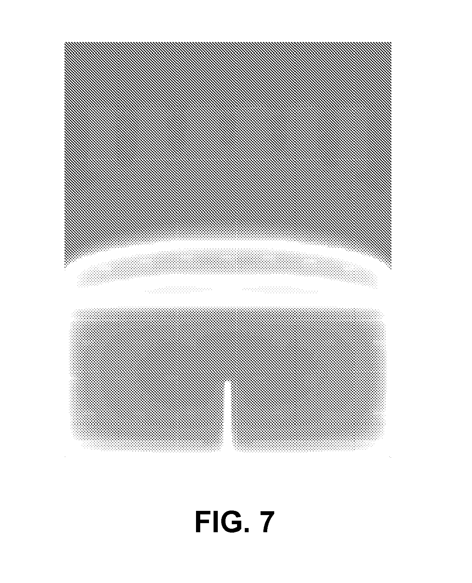

In FIG. 6 flare map accuracy obtained via a conventional convolution calculation and via a method according to an embodiment of the present invention is provided, illustrating that roughly the same accuracy can be obtained for both methods.
The flare effects obtained, may be provided in a matrix format wherein for different positions in the image field for the design, the overall contribution of flare is given. The latter may be provided as an image which thus is referred to as flare map, as indicated above. An example of a flare map obtained using a method according to the present invention is shown in FIG. 7. An example of a caculated flare map that can be obtained using this method, as shown by way of illustration in FIG. 7, is a full chip flare map calculated with a $5\mu m$ and calculated for a reticle design with the technique as described above.

Optionally, after the flare map is determined, the flare maps may be used for deriving information regarding flare effects on the design.

According to a further aspect, the present invention also relates to a method for designing and/or making a mask. The method comprises the same features and advantages as described in embodiments of the above described aspect, but it furthermore comprises using the obtained information regarding the flare for adjusting the initial design for the mask. The information regarding the flare thereby may be evaluated, in view of a threshold for developing the resist and the mask features in the initial design may be adjusted, e.g. in size, in order to compensate for the flare. The step of adjusting the mask design may comprise the steps of manipulating the pattern e.g. varying the dimensions, deleting or adding features, using software means such as E(electronic) D(esign) A(utomation) tools provided by companies such as Cadence or Numerical Graphics, both US-based companies or by ASM-L Masktools, a Netherlands-based company.

In a further optional step, from the design a mask is manufactured e.g. using a lithographic patterning process, the complexity of this patterning process being inversely proportional to the minimal feature size present in the design. The lithographic patterning technique used for the production of lithographic masks advantageously is a high quality lithographic technique which does not suffer from large deficiencies.

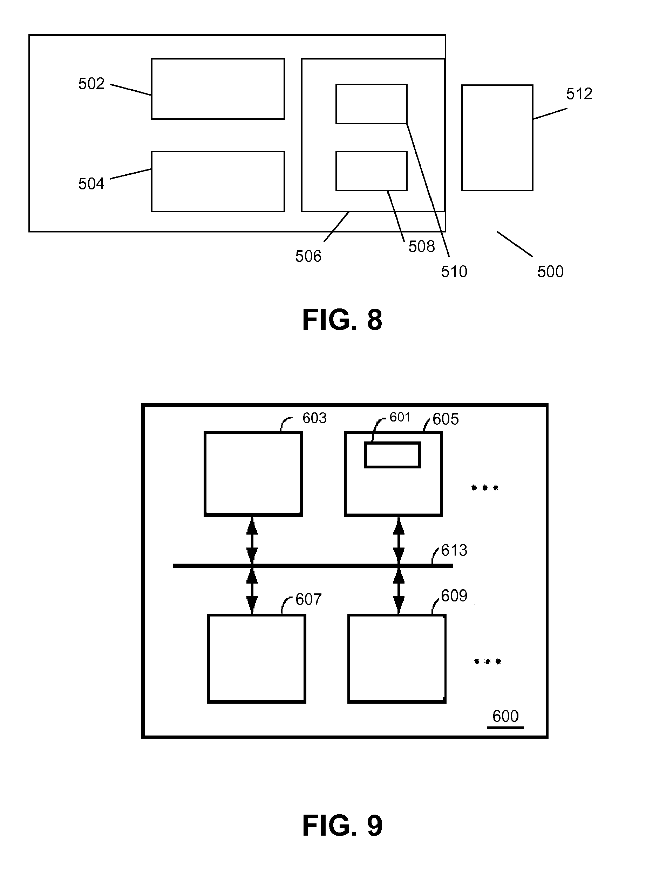

In a second aspect, the present invention relates to a system for determining flare. Such a system may for example comprise different components performing the functionality of the steps of methods according to embodiments of the first aspect described above. By way of illustration, optional and standard components of an exemplary system for determining flare is shown in FIG. 8. The system 500 may comprise an input means for obtaining a point spread function 502, an input means for obtaining an initial design of the mask 504 and a processing means 506 for determining a convolution of the point spread function and the initial design. The processing means 506 thereby is adapted for combining determining the convolution of the point spread function with the design with resizing of the design. The processing means thus may be adapted for resizing the design. Such resizing may be according to the resizing as set out above in the corresponding method. The processing means 506 may be adapted for resizing the initial design for using the resized initial design in at least part of the interval for which the convolution is to be determined. The processing means 506 may for example also comprise a resizing means 508 for resizing the design and a calculating means 510 adapted for calculating flare based on at least one convolution contribution of a convolution of the point spread function and the resized initial design. As set out above, these or other components may further have the same functionality as one or more steps of the methods described above. The system may be coupled to or comprise an Electronic Design Automation Tool. An output means 512 adapted for putting out flare information also may be provided.

In a further aspect, the present invention relates to a processing system wherein the method embodiments according to the present invention are implemented. An exemplary processing system 600 is shown in FIG. 9. FIG. 9 shows one configuration of processing system 600 that includes at least one programmable processor 603 coupled to a memory subsystem 605 that includes at least one form of memory, e.g., RAM, ROM, and so forth. A storage subsystem 607 may be included that has at least one disk drive and/or CD-ROM drive and/or DVD drive. In some implementations, a display system, a keyboard, and a pointing device may be included as part of a user interface subsystem 609 to provide for a user to manually input information. Ports for inputting and outputting data also may be included. More elements such as network connections, interfaces to various devices, and so forth, may be included, but are not illustrated in Fig. 9. The system may e.g. comprise an output means for outputting a flare map or an altered design. The various elements of the processing system 600 may be coupled in various ways, including via a bus subsystem 613 shown in Fig. 9 for simplicity as a single bus, but will be understood to those in the art to include a system of at least one bus. The memory of the memory subsystem 605 may at some time hold part or all (in either case shown as 611) of a set of instructions that when executed on the processing system 600 implement the step(s) of the method embodiments described herein. Thus, while a processing system 600 such as shown in Fig. 9 is prior art, a system that includes the instructions to implement aspects of the present invention is not prior art, and therefore Fig. 9 is not labelled as prior art.

It is to be noted that the processor 603 or processors may be a general purpose, or a special purpose processor, and may be for inclusion in a device, e.g., a chip that has other components that perform other functions. Thus, one or more aspects of the present invention can be implemented in digital electronic circuitry, or in computer hardware, firmware, software, or in combinations of them. Furthermore, aspects of the invention can be implemented in a computer program product tangibly embodied in a carrier medium carrying machine-readable code for execution by a programmable processor. Method steps of aspects of the invention may be performed by a programmable processor executing instructions to perform functions of those aspects of the invention, e.g., by operating on input data and generating output data. Accordingly, the present invention includes a computer program product which provides the functionality of any of the methods according to the present invention when executed on a computing device. Further, the present invention includes a data carrier such as for example a DVD, CD-ROM or a diskette which stores the computer product in a machine-readable form and which executes at least one of the methods of the invention when executed on a computing device. Nowadays, such software is often offered on the Internet or a company Intranet for download, hence the present invention includes transmitting the computer product according to the present invention over a local or wide area network.

It is to be understood that although preferred embodiments, specific constructions and configurations, as well as materials, have been discussed herein for devices according to the present invention, various changes or modifications in form and detail may be made without departing from the scope of this invention as defined by the appended claims. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method (200) for determining flare for lithographic processing, the method (200) comprising

   - obtaining (202) a point spread function for a lithographic processing system used for the lithographic processing,
   - obtaining (204) an initial design for at least part of a mask for use in said lithographic processing, the method (200) further comprising
   resizing (206) the initial design and calculating (208) flare based on at least a convolution contribution of a convolution of the point spread function and the resized initial design.

2. A method (200) according to claim 1, wherein calculating (208) flare comprises taking into account said at least a convolution contribution of a convolution of the point spread function and the resized initial design in a first convolution interval and taking into account a convolution contribution of a convolution of the point spread function and a non-resized initial design in a second convolution interval.

3. A method (200) according to any of the previous claims, wherein calculating (208) flare comprises taking into account a plurality of convolutions contributions of convolutions of point spread functions and resized initial designs for different convolution intervals.

4. A method (200) according to any of the previous claims, wherein calculating (208) flare comprises obtaining different convolution contributions for different convolution intervals, whereby the different convolution intervals are logarithmic intervals.

5. A method (200) according to any of the previous claims, wherein for different convolution contributions, the value used for the point spread function in the contribution is the average value of the point spread function intensity in the corresponding convolution interval or an approximation thereof.

6. A method (200) according to any of the previous claims, said method (200) furthermore comprising determining, based on calculated flare, a flare map for a predetermined lithographic process.

7. A method (200) according to any of the previous claims, wherein said resizing (206) of the initial design in the at least one convolution contribution is selected so as to determine a convolution contribution expressing the flare contribution at larger distance from a flare source with a different data density in the design than a convolution contribution describing the flare contribution at shorter distance from the flare source.

8. A method (200) according to any of the previous claims, wherein for a plurality of convolution contributions, the amount of resizing is larger for convolution contributions expressing the flare contribution at larger distance from the flare source, than the amount of resizing for convolution contributions expressing the flare contribution at short distance from the flare source.

9. A method for designing a mask for lithographic processing, the method comprising

   - determining information regarding flare based on a method (200) according to any of claims 1 to 8,
   - evaluating said information regarding flare as function of a threshold for developing resist, and
   - adjusting an initial design for said mask as function of said evaluated information regarding flare.

10. A mask for lithographic processing designed using a method according to claim 9.

11. A system (500) for determining flare for a lithographic process, the system comprising

   - an input means adapted for obtaining a point spread function (502),
   - an input means adapted for obtaining an initial design of the mask (504), and
   - a processing means (506) comprising a resizing means (508) adapted for resizing the initial design and a calculating means (510) adapted for calculating flare based on at least a convolution contribution of the point spread function and the resized initial design.

12. A system for designing a lithographic mask, the system comprising

   - a system for determining flare according to claim 11,
   - an evaluation means for evaluating the determined flare as function of a threshold for said resist, and
   - a processing means for deriving based on said evaluated determined flare an altered design.

13. A computer program product for executing a method according to any of claims 1 to 8.

14. A machine readable data storage device storing the computer program product of claim 13.

15. Transmission of the computer program product according to claim 13 over a local or wide area telecommunications network.

## Fig. 1a – PRIOR ART

## Fig. 1b – PRIOR ART

EP 2 110 707 A1

**Fig. 1c – PRIOR ART**

**Fig. 1d – PRIOR ART**

EP 2 110 707 A1

Fig. 1e – PRIOR ART

Fig. 2

Fig. 3a

# Fig. 3b

# FIG. 4

**Fig. 5**

y = 1.0796x - 0.0033

**Fig. 6**

**FIG. 7**

502

504

512

506

508

510

500

**FIG. 8**

603

601

605

613

607

609

600

**FIG. 9**

Europäisches
Patentamt

European
Patent Office

Office européen
des brevets

# EUROPEAN SEARCH REPORT

**Application Number**

EP 08 15 4841

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KRAUTSCHIK C G ET AL: "Implementing flare compensation for EUV masks through localized mask CD resizing" PROCEEDINGS OF THE SPIE - THE INTERNATIONAL SOCIETY FOR OPTICAL ENGINEERING SPIE-INT. SOC. OPT. ENG USA, vol. 5037, 2003, pages 58-68, XP002508441 ISSN: 0277-786X * the whole document * | 1-15 | INV. G03F1/14 G03F7/20 |
| X | KIM I ET AL: "Flare mitigation strategies in extreme ultraviolet lithography" MICROELECTRONIC ENGINEERING, ELSEVIER PUBLISHERS BV., AMSTERDAM, NL, vol. 85, no. 5-6, 9 February 2008 (2008-02-09), pages 738-743, XP022678594 ISSN: 0167-9317 * the whole document * -& SCHELLENBERG F M ET AL: "Layout compensation for EUV flare" PROCEEDINGS OF THE SPIE, SPIE-INT. SOC. OPT. ENG, vol. 5751, 2005, pages 320-329, XP002508442 USA ISSN: 0277-786X * the whole document * | 1-15 | |
| | | | TECHNICAL FIELDS SEARCHED (IPC) |
| | | | G03F |
| X | WO 2005/082063 A (MENTOR GRAPHICS CORP [US]; WORD JAMES [US]; COBB NICOLAS B [US]; GRANI) 9 September 2005 (2005-09-09) * claims 1-5 * * page 1 - page 2 * * page 4 - page 5 * | 1,3,6, 9-15 | |
| A | WO 02/27403 A (UNIV CALIFORNIA [US]) 4 April 2002 (2002-04-04) * the whole document * | 1-15 | |

-/--

The present search report has been drawn up for all claims

| Place of search | Date of completion of the search | Examiner |
|---|---|---|
| Munich | 7 January 2009 | von Hentig, Tanja |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

**Application Number**

EP 08 15 4841

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | LORUSSO G F ET AL: "Extreme ultraviolet lithography at IMEC: Shadowing compensation and flare mitigation strategy" JOURNAL OF VACUUM SCIENCE AND TECHNOLOGY B: MICROELECTRONICS AND NANOMETER STRUCTURES 2007 AVS SCIENCE AND TECHNOLOGY SOCIETY US, vol. 25, no. 6, 2007, pages 2127-2131, XP002508443 * the whole document * | 1-15 | |

-----

TECHNICAL FIELDS
SEARCHED      (IPC)

The present search report has been drawn up for all claims

| Place of search | Date of completion of the search | Examiner |
|---|---|---|
| Munich | 7 January 2009 | von Hentig, Tanja |

CATEGORY OF CITED DOCUMENTS

X : particularly relevant if taken alone
Y : particularly relevant if combined with another
      document of the same category
A : technological background
O : non-written disclosure
P : intermediate document

T : theory or principle underlying the invention
E : earlier patent document, but published on, or
      after the filing date
D : document cited in the application
L : document cited for other reasons

................................................................................................

& : member of the same patent family, corresponding
      document

EPO FORM 1503 03.82 (P04C01)

**ANNEX TO THE EUROPEAN SEARCH REPORT**

**ON EUROPEAN PATENT APPLICATION NO.**                    EP 08 15 4841

This annex lists the patent family members relating to the patent documents cited in the above-mentioned European search report.
The members are as contained in the European Patent Office EDP file on
The European Patent Office is in no way liable for these particulars which are merely given for the purpose of information.

07-01-2009

| Patent document cited in search report | | Publication date | Patent family member(s) | | Publication date |
|---|---|---|---|---|---|
| WO 2005082063 | A | 09-09-2005 | EP | 1723568 A2 | 22-11-2006 |
| | | | JP | 2007524255 T | 23-08-2007 |
| WO 0227403 | A | 04-04-2002 | AU | 8883101 A | 08-04-2002 |
| | | | US | 6815129 B1 | 09-11-2004 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6686102 B

**Non-patent literature cited in the description**

- **Kafai Li et al.** Scattered light: the increasing problem for 193nm exposure tools and beyond. *SPIE proceedings,* 2001, vol. 4346